Europäisches Patentamt

European Patent Office

Office européen des brevets

(11) Numéro de publication: **0 489 344 A1**

# DEMANDE DE BREVET EUROPEEN

(21) Numéro de dépôt: **91120226.5**

(22) Date de dépôt: **27.11.91**

(51) Int. Cl.⁵: **H03K 17/96**

(30) Priorité: **18.02.91 BE 9100157**
      **03.12.90 DE 9016410 U**

(43) Date de publication de la demande:
     **10.06.92 Bulletin 92/24**

(84) Etats contractants désignés:
     **AT BE CH DE DK ES FR GB GR IT LI LU NL SE**

(71) Demandeur: **INTERLINK ELECTRONICS EUROPE**
     **B.P. 8, Zone Industrielle**
     **L-6401 Echternach(LU)**

(72) Inventeur: **Rohde, Rudi**
     **Eselsgrundweg 16**
     **W-6900 Heidelberg 1(DE)**
     Inventeur: **Serban, Bogdan C.**
     **6 Rue Pierre Neyertz**
     **L-4405 Soleuvre(LU)**
     Inventeur: **Witte, Michel**
     **248 rue de Luxembourg**
     **L-8077 Bertrange(LU)**
     Inventeur: **Hagen, Jannick**
     **40 route de Luxembourg**
     **L-3515 Dudelange(LU)**

(74) Mandataire: **Meyers, Ernest et al**
     **Office de Brevets Meyers & Van Malderen**
     **261 route d'Arlon B.P. 111**
     **L-8002 Strassen(LU)**

(54) Clavier à touches et procédé d'identification d'une touche activée.

(57) La clavier est constitué d'une grille de touches individuelles associées, chacune, à un capteur de force dont la résistance électrique diminue proportionnellement à une force appliquée à sa surface. Pour identifier une touche activée, on injecte des signaux d'identification sur les lignes et à partir des signaux recueillis sur les bornes, on identifie la ligne recherchée. La colonne recherchée est déterminée de manière analogue en injectant des signaux d'identification dans les colonnes.

Fig.1

La présente invention concerne un clavier à touches pour panneau de commande comprenant une plaque de base, une plaque de décor pourvue de marquages d'identification de touches auxquelles sont attribuées des fonctions bien précises, ainsi que des capteurs sensibles à une pression d'activation disposée en-dessous de chaque touche entre la plaque de base et la plaque de décor. L'invention concerne également un procédé d'identification d'une touche activée d'un clavier constitué d'une grille de m lignes et n colonnes de touches d'un tel clavier.

Sans y être limitée, l'invention vise notamment des claviers pour des panneaux de commandes destinés à déclencher et superviser des opérations et fonctionnements de toutes sortes de machines, appareils, installations, etc. Un clavier de ce genre est, par exemple, connu par la demande de brevet EP-0 210 386 qui propose un panneau de commandes, de structure stratifiée, comprenant une feuille ou plaque dure formant support avec une couche de couverture entre lesquelles est disposé en sandwich un cristal qui réagit à une pression extérieure par l'émission ou la modification d'un signal électrique.

La demande de brevet européen No EP-0 366 832 propose une couverture d'un clavier à touches d'un panneau de commandes qui se présente sous forme d'une plaque rigide déposable sur la surface de manoeuvre du clavier et qui présente aux endroits correspondants aux touches du clavier au moins une zone de transmission de pression qui est souple ou à rigidité réduite.

Tous ces claviers présentent, suivant leur type d'application, certains inconvénients. C'est ainsi, par exemple, que ces claviers à touches ou panneaux de commande sont sensibles à des influences mécaniques extérieures et peuvent être facilement détériorés par suite de coups ou de mauvais traitements. Il existe, par conséquent, un besoin urgent en claviers à touches ou panneaux de commande qui résistent mieux à des attaques mécaniques extérieures, ne fût-ce qu'à titre de prévention des risques d'actes de vandalisme. Il y a lieu de mentionner aussi que les claviers connus sont relativement sensibles à des vibrations extérieures.

On connaît, par ailleurs, des capteurs de force du genre décrit dans le brevet US 4,314,228 qui sont maintenant connus sous la marque déposée FSR qui est l'abréviation de "Force Sensing Resistor". Un tel capteur est essentiellement constitué d'une mince pellicule semi-conductrice pouvant être formée par de minuscules particules, par exemple de bisulfure de molybdène d'une taille de l'ordre de 1 à 10 microns noyés dans une résine de support. Une telle pellicule présente une certaine résistance superficielle qui, lorsque la pellicule est appliquée contre une surface conductrice peut être réduite par suite d'une augmentation du nombre de points de contact avec cette surface conductrice sous l'effet d'une pression localisée. Un mode d'exécution avantageux consiste à associer une telle pellicule FSR à une pellicule sur laquelle est déposée un réseau conducteur sous forme de deux peignes d'électrodes en disposition interdigitale. Ces deux pellicules sont scellées l'une à l'autre de façon à ce que les peignes d'électrodes effleurent la surface de la couche semi-conductrice FSR. Lorsqu'aucune force n'est appliquée à un tel FSR, la résistance entre les bornes des peignes d'électrodes est très élevée, généralement de l'ordre de plusieurs mégaohms. Par contre, lorsque le FSR est soumis à une force perpendiculairement à sa surface, la résistance diminue approximativement de façon exponentielle. Cette propriété pourrait être mise à profit dans un clavier en prévoyant, à la place des capteurs électromécaniques habituels des capteurs du type FSR, d'autant plus que, vu la grande sensibilité de ce type de capteurs, il pourrait réagir à une pression locale appliquée à travers une plaque de protection plus ou moins rigide qui serait pourvue à l'extérieur, des marquages d'identification des touches. Malheureusement, des claviers dont les touches seraient associées à des capteurs de force FSR n'ont pas pu être réalisées jusqu'à présent à cause de problèmes d'identification des touches activées. En effet, en utilisant un clavier comprenant une grille ou matrice de capteurs FSR formant les touches de clavier, il suffirait, pour connaître la touche actionnée par un doigt ou un stylet, de déterminer celui de tous les capteurs dont la résistance est la plus faible. Il faudrait donc appliquer successivement un signal électrique à chaque touche et sélectionner, à la sortie, le signal, par exemple avec la plus grande amplitude, qui devrait, en principe, correspondre à la touche activée. On sélectionnerait alors le signal dont l'amplitude dépasse un seuil prédéterminé et qui, de ce fait, devrait correspondre aux capteurs avec la plus faible résistance électrique.

Malheureusement, en procédant de cette manière, on n'est pas du tout certain d'avoir localisé, sans ambiguïté, le capteur correspondant au lieu géométrique de la pression locale la plus faible. Il y a plusieurs raisons à cette incertitude. Lorsqu'une force normale est appliquée à la surface de la plaque de décor d'un tel clavier, celle-ci est distribuée sur la grille des capteurs FSR. En raison de la déflexion locale de la plaque, éventuellement semi-rigide et mécaniquement anisotrope, la pression est localement plus élevée au lieu géométrique de l'application de la force, pour décroître ensuite à mesure qu'on s'éloigne de ce lieu. Cette répartition de la pression sur la grille de capteurs est en outre influencée par une couche d'une matière compressible généralement insérée entre la grille et la plaque de protection qui, elle aussi, est anisotrope et, par conséquent, diffuse la pression de manière irrégulière. Par conséquent, ce n'est pas seulement le capteur correspondant au lieu géométrique de l'application de la pression qui est activé, mais également les capteurs avoisinants suivant leur éloignement de ce lieu.

Une seconde raison est que tous les capteurs FSR n'ont pas des propriétés et caractéristiques intrinsèques absolument identiques. Le cumul de ces deux causes rend difficile une identification de la touche correcte en cas de scrutation ponctuelle de toutes les touches comme expliqué ci-dessus.

Le but de la présente invention est de prévoir un nouveau clavier à touches qui présente une meilleure résistance aux influences mécaniques extérieures, ainsi qu'un procédé d'identification d'une touche activée qui est à la fois précis et rapide.

Pour atteindre cet objectif, la présente invention propose un clavier à touches pour panneaux de commandes du genre décrit dans le préambule qui est caractérisé en ce que les capteurs sont des capteurs de force à résistance variable du type FSR et en ce que la plaque de décor est une plaque semi-rigide.

La structure peut également comporter une couche d'un matériau compressible entre la plaque de base et la plaque de décor. Les capteurs de force sont alors insérés, en-dessous des touches ou des zones de touches, soit entre la plaque de décor et la couche compressible, soit entre celle-ci et la plaque de base.

La plaque de décor peut présenter un marquage d'une grande finesse, c'est-à-dire de faible distance entre les différentes touches, ce qui permet un grand pouvoir de résolution. Le marquage des touches peut être réalisé sous forme de bandes sans interruption ou d'une autre manière. Il est également possible de prévoir en-dessous de la plaque de décor des rainures permettant d'introduire et de retirer des bandes pourvues des marquages des touches ce qui permet un changement rapide du marquage et de l'identification des touches.

La plaque de décor du clavier selon la présente invention est étanche aux poussières et à l'eau, et, suivant les besoins, résistante aux agents chimiques et/ou aux actes de vandalisme. Compte tenu des propriétés des capteurs FSR, la force nécessaire à l'activation des touches est réglable. La plaque de décor peut présenter une surface tout à fait lisse et être réalisée en métal en verre ou en matière synthétique selon une présentation et un design conformément aux voeux de l'utilisateur. En dehors d'une durée de vie longue, ces plaques de décor se caractérisent par une faible épaisseur et la possibilité d'une combinaison éventuelle avec des éléments électrooptiques.

Les capteurs réagissent par une résistance variable qui diminue en fonction de la force d'activation des touches. Chaque capteur comporte, de manière connue en soi, une pellicule semi-conductrice laminée à une pellicule avec deux peignes d'électrodes. Lorsqu'une pression est appliquée sur un tel capteur, la couche semi-conductrice shunte plus ou moins les électrodes voisines des deux peignes et réduit la résistance entre ceux-ci.

L'invention concerne également un procédé d'identification d'une touche activée d'un tel clavier constitué d'une grille de m lignes et n colonnes de touches individuelles, associées chacune à un capteur de force dont la résistance électrique diminue proportionnellement à une force appliquée à sa surface, dans lequel les m x n capteurs sont disposés en sandwich entre une plaque rigide de support et une plaque semi-rigide de protection et de décor portant les marques d'identification des touches, caractérisé en ce que l'on injecte simultanément sur les m bornes des m lignes de capteurs m signaux électriques différents et dissociables entre eux, en ce que l'on recueille sur les bornes des n colonnes les m signaux, en ce que l'on détermine parmi les m signaux le signal i dont le degré de déformation dépasse un seuil prédéterminé et qui correspond à la ligne i dans laquelle se trouve le capteur $C_{ij}$ le plus activé, en ce que l'on injecte simultanément sur les n bornes des n colonnes de capteurs n signaux électriques différents et dissociables entre eux, en ce que l'on recueille sur les bornes des m lignes les n signaux en ce que l'on détermine parmi les n signaux, le signal j dont le degré de déformation dépasse un seuil prédéterminé et qui correspond à la colonne j dans laquelle se trouve le capteur $C_{ij}$ le plus activé.

A titre de confirmation du résultat d'identification, il est possible de répéter, au moins une fois, toutes les opérations de détermination de la touche $C_{ij}$.

Les déformations détectées sur les signaux lors du passage par les capteurs peuvent être la modification de leur amplitude suite au changement de résistance électrique des capteurs. Il est toutefois également possible de détecter d'autres modifications tel que le déphasage ou la fréquence, lorsque les capteurs sont intégrés dans un circuit oscillateur.

D'autres particularités et caractéristiques de l'invention ressortiront de la description détaillée de plusieurs modes de réalisation avantageux, présentés ci-dessous, à titre d'illustration, en référence aux dessins annexés dans lesquels:

- les figures 1 à 4 représentent schématiquement des coupes partielles transversales à travers quatres modes d'exécution d'un clavier conformément à la présente invention et dans lesquelles on a utilisé les mêmes chiffres de référence pour désigner les mêmes éléments;

- la figure 5 montre schématiquement une coupe verticale à travers un clavier dont les touches sont constituées par des capteurs FSR;
- la figure 6 montre schématiquement une grille comprenant 4 lignes et 4 colonnes de capteurs;
- la figure 7 montre schématiquement les signaux d'identification destinés à être injectés sur les lignes et les colonnes de la grille de la figure 6;
- la figure 8 représente schématiquement le signal détecté sur les colonnes lorsque les signaux d'identification sont injectés sur les lignes de la grille et
- la figure 9 montre schématiquement le signal détecté sur les lignes de la grille lorsque les signaux d'identification sont injectés sur les colonnes de la grille.

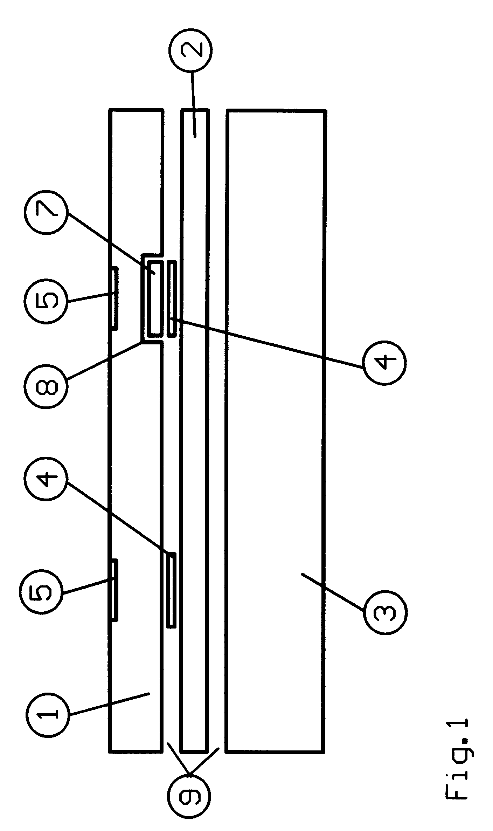

La figure 1 montre schématiquement une coupe d'une partie d'un panneau de commande se présentant sous forme d'une structure stratifiée et comprenant une plaque de décor 1 pourvue de marquages, des capteurs 4 sensibles à pression, une couche compressible 2 et une plaque de base 3. Les touches sont représentées par la référence 5. Il est possible de prévoir à la face inférieure de la plaque de décor une ou des fenêtres 7 dans lesquelles peuvent être introduites des bandes amovibles 8 pour pouvoir utiliser des textes différents. La référence 9 symbolise une colle entre les différentes couches.

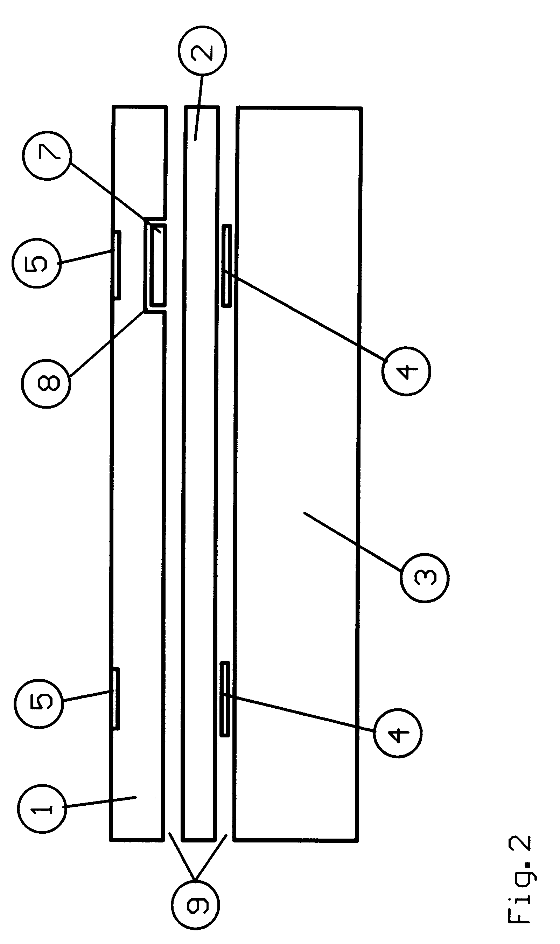

La figure 2 représente schématiquement la même structure que celle de la figure 1 avec la différence que, contrairement au mode d'exécution selon la figure 1, les capteurs 4 sensibles à la pression se trouvent entre la couche élastique compressible 2 et la plaque de base 3.

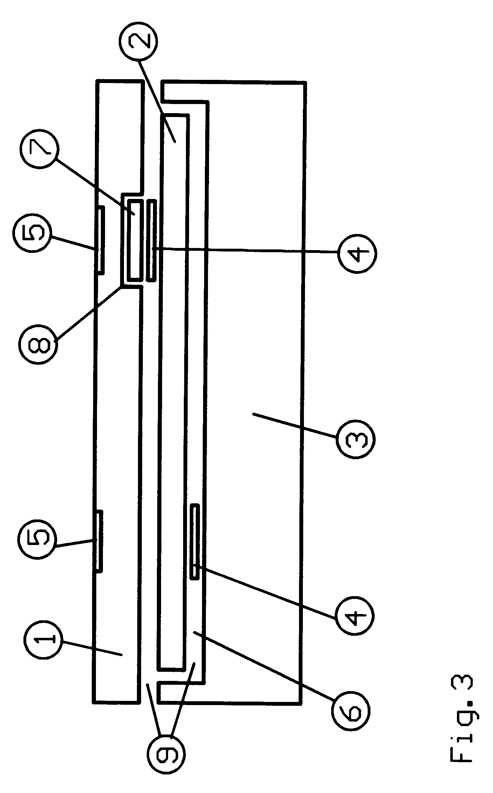

La figure 3 illustre la possibilité de concevoir la surface supérieure de la plaque de base 3 en forme d'assiette 6 dans laquelle peut être logée la couche compressible 2, les capteurs de pression 4 pouvant se trouver, soit entre la couche compressible 2 et la plaque de base 3, soit entre la couche compressible 2 et la plaque de décor 1.

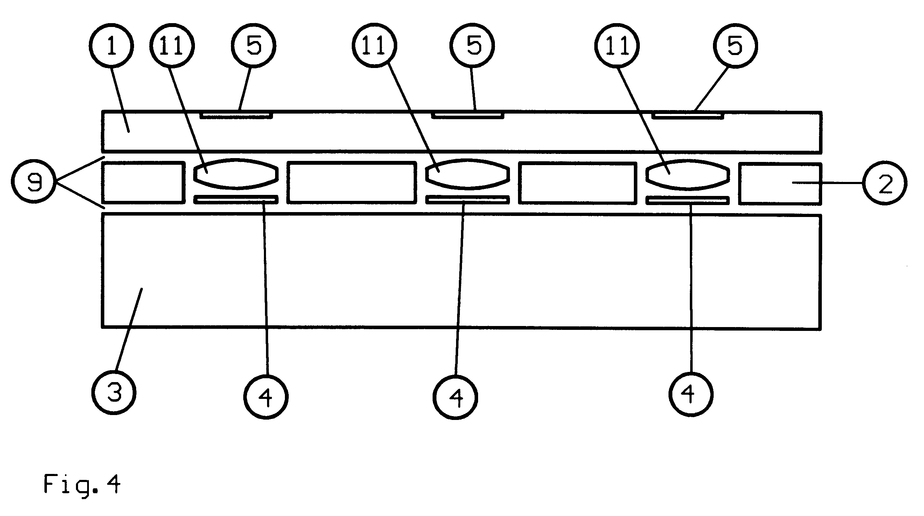

La figure 4 représente finalement une couche compressible 2 pourvue d'encoches en-dessous des touches 5 de la plaque de décor 1 et dans lesquelles se trouvent les capteurs 4 et des pastilles 10 de transmission de pression. Ces pastilles 10 ont des faces supérieures et inférieures convexes et permettent une meilleure transmission de la pression sur les capteurs 4.

Au lieu de réaliser l'assemblage avec de la colle il est possible d'imprimer l'une sur l'autre les différentes couches, y compris les FSR et les pastilles 10, par exemple par un procédé sérigraphique.

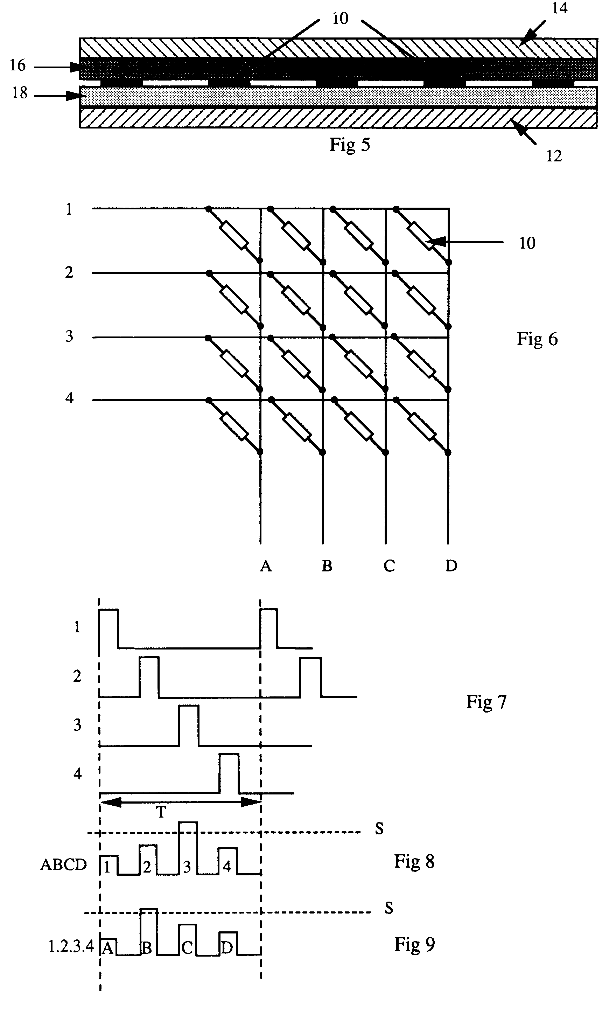

La figure 5 représente schématiquement un clavier comprenant une grille de capteurs 10 du type FSR placée en sandwich entre deux couches 16 et 18 d'un matériau compressible, prises, à leur tour, en sandwich entre une plaque de base rigide 12 et une plaque semi-rigide de décor et de protection 14.

La figure 6 montre schématiquement un réseau de 16 capteurs 10 pour un clavier de commande selon la figure 5. Ces 16 capteurs sont disposés suivant une grille ou matrice de 4 lignes 1, 2, 3, 4 et 4 colonnes A, B, C, D.

On va maintenant décrire le procédé d'identification de celui des 16 capteurs FSR qui est activé par une pression ponctuelle localisée. La première phase consiste, par exemple, à localiser d'abord sur laquelle des 4 lignes de la grille de la figure 6 le capteur activé a le plus de probabilité de se trouver. A cet effet, on injecte sur chacune des 4 lignes 1 à 4 des signaux électriques d'identification. Il faut donc 4 signaux qui sont représentés sur la figure 7 et qui sont numérotés 1 à 4. Comme le montre cette figure, il s'agit de simples signaux avec une période T, identiques dans leur configuration, mais déphasés un quart de période les uns par rapport aux autres. Ces signaux sont ensuite recueillis aux 4 bornes des colonnes A, B, C, D qui, pour les besoins de la cause peuvent être connectées entre elles.

La figure 8 représente un exemple d'un signal détecté sur les bornes A, B, C, D, ce signal représentant la somme pondérée des signaux 1, 2, 3, 4. Suivant la nature des capteurs FSR du clavier et suivant l'amplitude des signaux d'identification de la figure 7 on détermine un seuil S d'amplitude qui sera probablement dépassé par un signal d'identification après le passage de celui-ci à travers un capteur activé. Dans l'exemple de la figure 8 seule la portion correspondant au signal 3 dépasse ce seuil S. Etant donné que cette portion est issue du signal injecté dans la ligne 3 il faut en conclure que c'est dans la 3e ligne que se trouve le capteur FSR le plus activé.

La seconde phase consiste à déterminer la colonne dans laquelle se trouve le capteur le plus activé. A cet effet on procède d'une manière analogue à la détermination de la ligne telle que décrite ci-dessus. On injecte donc dans les 4 colonnes A, B, C, D 4 signaux d'identification utilisés précédemment. On recueille ensuite ces signaux sur les lignes 1, 2, 3, 4 dont les bornes peuvent être connectées entre elles pour les besoins de la cause. En supposant que l'on recueille sur les 4 lignes le signal représenté sur la figure 19 on sélectionne la portion dépassant le seuil d'amplitude S. En l'occurrence il s'agit du signal injecté dans la colonne B, ce qui signifie que le capteur le plus activé se trouve dans la colonne B de la grille.

Ces deux phases d'identification sont nécessaires et suffisantes pour déterminer, sans ambiguïté, lequel des capteurs de la grille de la figure 6 est activé étant donné que l'on connaît la ligne et la colonne du capteur recherché, en l'occurrence, dans l'exemple représenté dans la ligne No 3 et la colonne B.

Le mode d'identification des touches proposé par la présente invention a, outre la précision, l'avantage d'être plus rapide qu'une scrutation ponctuelle de chacun des capteurs. En effet, en supposant que l'on ait un clavier avec une grille de m lignes et de n colonnes de capteurs, il suffit d'analyser m + n capteurs pour localiser le capteur le plus activé alors qu'une scrutation ponctuelle nécessite l'analyse de m x n signaux.

Pour être tout à fait certain du résultat de l'identification on peut répéter le procédé d'identification à titre de confirmation.

Au lieu de balayer toutes les lignes et toutes les colonnes en une fois, il est possible, suivant la grandeur du clavier de définir des groupes par ex. $m_{/2}$, $m_{/3}$... etc. de lignes et $n_{/2}$, $n_{/3}$... etc. de colonnes et d'explorer successivement ces groupes pour identifier la touche activée.

**Revendications**

1. Clavier à touches pour panneaux de commande comprenant une plaque de base (3), une plaque de décor (1) pourvue de marquages d'identification de touches (5) auxquelles sont attribués des fonctions bien précises, ainsi que des capteurs sensibles à une pression d'activation disposés en-dessous de chaque touche (5) entre la plaque de base (3) et la plaque de décor (1), caractérisé en ce que les capteurs sont des capteurs de force (4) à résistance variable du type FSR et en ce que la plaque de décor est une plaque semi-rigide.

2. Clavier selon la revendication 1, caractérisé par une couche (2) de matière compressible disposée entre les capteurs (4) et la plaque de décor (1).

3. Clavier selon l'une quelconque des revendications 1 ou 3, caractérisé par une couche de matière compressible (2) disposée entre les capteurs (4) et la plaque de base (3).

4. Clavier selon l'une quelconque des revendications 2 ou 3, caractérisé en ce que la couche compressible (2) est logée dans une assiette (6) prévue dans la face supérieure de la plaque de base (3).

5. Clavier selon la revendication 1, caractérisé en ce que la plaque de décor (1) comporte à sa face inférieure des fenêtres (7) pour l'introduction de bandes de marquage amovibles (8).

6. Clavier selon la revendication 2, caractérisé en ce que la couche compressible comporte des encoches en-dessous des touches (5), dans lesquelles sont logés les capteurs (4) et des pastilles (11) à faces convexes de transmission de pression.

7. Procédé d'identification d'une touche activée d'un clavier constitué d'une grille de m lignes et n colonnes de touches individuelles associées, chacune, à un capteur de force dont la résistance électrique diminue proportionnellement à une force appliquée à sa surface, dans lequel les m x n capteurs sont disposés en sandwich entre une plaque rigide de support et une plaque semi-rigide de protection portant les marques d'identification des touches, caractérisé en ce que l'on injecte simultanément sur les m bornes des m lignes du capteur m signaux électriques différents et dissociables entre eux, en ce que l'on recueille sur les bornes des n colonnes les m signaux, en ce que l'on détermine parmi les m signaux le signal i dont le degré de déformation dépasse un seuil prédéterminé et qui correspond à la ligne i dans laquelle se trouve le capteur $C_{ij}$ le plus activé, en ce que l'on injecte simultanément sur les n bornes des n colonnes de capteurs n signaux électriques différents et dissociables entre eux, en ce que l'on recueille sur les bornes des m lignes les n signaux, en ce que l'on détermine parmi les n signaux le signal j dont le degré de déformation dépasse un seuil prédéterminé et qui correspond à la colonne j dans laquelle se trouve le capteur $C_{ij}$ le plus activé.

8. Procédé selon la revendication 7, caractérisé en ce que l'on répète, au moins une fois, toutes les opérations de détermination de la touche $C_{ij}$ à titre de confirmation de l'identification.

9. Procédé selon la revendication 7, caractérisé en ce que la détermination des signaux i et j comporte la détermination du signal dont l'amplitude dépasse un seuil prédéterminé.

10. Procédé selon la revendication 7, caractérisé en ce que les bornes des colonnes sont reliées entre elles et les bornes des lignes sont reliées entre elles pour recueillir les signaux d'identification.

Fig.1

EP 0 489 344 A1

Fig.2

Fig. 3

Fig. 4

EP 0 489 344 A1

Fig 5

Fig 6

Fig 7

Fig 8

Fig 9

11

Office européen
des brevets

**RAPPORT DE RECHERCHE EUROPEENNE**

Numero de la demande

EP    91 12 0226

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5 ) |
|---|---|---|---|
| Y | GB-A-2 163 602 (CASIO)<br>* le document en entier *<br>--- | 1 | H03K17/96 |
| D,Y | GB-A-2 064 873 (TCHEREPIN)<br>* le document en entier *<br>--- | 1 | |
| A | GB-A-2 077 508 (WEATHERLEY)<br>* le document en entier *<br>--- | 1 | |
| A | MEASUREMENT + CONTROL<br>vol. 18, no. 7, Septembre 1985, LONDRES GB<br>pages 262 - 265;<br>ROBERTSON ET AL: 'tactile sensor system for robotics'<br>* le document en entier *<br>--- | 1 | |
| A | GB-A-2 191 340 (AMALGAMATED WIRELESS LTD)<br>* le document en entier *<br>--- | 5 | |
| A | EP-A-0 259 894 (WACOM CO. , LTD)<br>* colonne 12, ligne 44 - colonne 13, ligne 14; figures 9,10 *<br>--- | 7,9 | **DOMAINES TECHNIQUES RECHERCHES (Int. Cl.5 )** |
| A | US-A-4 481 815 (OVERTON)<br>* colonne 6, ligne 21 - colonne 8, ligne 14; figures 2-12 *<br>--- | 1,7,9 | H03K |
| A | GB-A-2 047 448 (SINGER CO.)<br><br>----- | | |

Le présent rapport a été établi pour toutes les revendications

| Lieu de la recherche | Date d'achèvement de la recherche | Examinateur |
|---|---|---|
| LA HAYE | 13 MARS 1992 | FEUER F.S. |